# EUROPEAN PATENT SPECIFICATION

(11) **EP 1 266 392 B1**
(45) Date of publication and mention of the grant of the patent: **07.04.2010**
(21) Application number: 01920976.6
(22) Date of filing: 14.02.2001
(51) Int. Cl.: H01J 37/305, H01J 37/30

(54) **SYSTEM FOR IMAGING A CROSS-SECTION OF A SUBSTRATE**
SYSTEM ZUM ABBILDEN EINES PROBENQUERSCHNITTS
SYSTEME D'IMAGERIE D'UNE SECTION DROITE DE SUBSTRAT

(30) Priority: 25.02.2000 US 513826
(43) Date of publication of application: 18.12.2002
(73) Proprietor: FEI COMPANY, Hillsboro, OR 97124-5830 (US)
(72) Inventor: BERGER, Steve, Newburyport, MA 01950 (US); SCIPIONI, Lawrence, Danvers, Essex, MA 01923 (US)
(74) Representative: Bakker, Hendrik
(86) International application number: PCT/US2001/040108
(87) International publication number: WO 2001/063266

(56) References cited:
- EP-A- 0 927 880
- WO-A-99/13500
- WO-A-99/41765
- BISCHOFF L ET AL: "HIGH CURRENT FIB SYSTEM FOR MICROMECHANICS APPLICATION" MICROELECTRONIC ENGINEERING, ELSEVIER PUBLISHERS BV., AMSTERDAM, NL, vol. 21, no. 1 / 4, 1 April 1993 (1993-04-01), pages 197-200, XP000361077 ISSN: 0167-9317

## Description

The invention relates to an apparatus for imaging a cross-section of a work-piece having a front surface, said apparatus comprising an ion beam projection column oriented along a column axis, said ion beam projection column equipped to project an aperture image on said work-piece , and a work-piece support equipped to hold the work-piece.

The invention further relates to a method using such an apparatus for forming and imaging said cross-section.

Such an apparatus is known from European Patent application EP-0927880.

Integrated circuits frequently incorporate devices that extend deeply into a semiconductor substrate or wafer. In the manufacture of such integrated circuits, it is desirable to periodically inspect the structure of these devices. In most cases, this is achieved by inspecting a cross-section of the wafer on which the integrated circuits are formed.
The conventional method for inspecting a cross-section of a semiconductor substrate generally includes the removal of material from the substrate in order to expose a cross-sectional surface. This is followed by the illumination of that surface by an imaging beam.
The step of exposing a cross-sectional surface is typically accomplished by scanning the front surface of the semiconductor substrate with a focused ion-beam to excavate a trench. The vertical wall of this trench forms the cross-sectional surface to be imaged by the imaging beam.
The imaging beam is typically a particle beam that scans the cross sectional surface exposed by the scanning focused ion-beam. The interaction of this particle beam with the cross-sectional surface results in the emission of charged particles. These charged particles are detected by a detector that provides data to a processor for transformation of the data into a cross-sectional image of the semiconductor substrate.

The apparatus known from European Patent application EP-0927880 comprises an ion beam projection column oriented along a first axis and illuminating the work-piece to form a cross-section thereon, and an electron beam column oriented along a second axis that intersects said first axis at a predetermined angle, said electron beam column generating a focused electron beam illuminating the cross-section.

A disadvantage of the known apparatus is that an apparatus with both an ion beam projection column and an electron beam column is needed.

It is an objective of the invention to provide a simpler apparatus.

To this end the apparatus according to the invention is **characterized in that** the ion beam projection column is switchable between a cutting mode in which an aperture image is projected onto said work-piece, and an imaging mode in which a focused ion beam illuminates said work-piece under a second angle relative to the column axis, and the work-piece holder has a cutting position in which said support holds said front surface at a first angle relative to said column axis, and an imaging position in which said support holds said front surface at a second angle relative to said column axis.

The cutting mode is well suited for excavating a region of the work piece but cannot readily be used to form an image, while the imaging mode is well suited for imaging but somewhat inefficient for excavation.

It is noted that apparatus using a scanning focused ion beam for both cutting and imaging are known. Because the ion beam is focused to a small point, the source of ions must be one that is capable of providing a large ion current in a small area to obtain a high cutting speed.
Although the ion source can be a liquid metal source, the brightness of such a source is no longer needed in order to excavate a region of the work piece. Assuming a constant ion current, the ratio of (*i*) the brightness required of a focused ion beam system to (*ii*) the brightness required of a projection beam system depends on the ratio of the area illuminated by the focused ion beam to the area of the projected aperture in the projection beam system. For a typical focused ion beam illuminating a circle with a one-hundred nanometre diameter and a typical projected aperture having linear dimensions of ten microns, the brightness requirement of the ion source is reduced by a factor of ten thousand, or, vice versa, for similar brightness, the total ion current is increased ten thousand fold.
Because the ion source in a projection system need not have such high brightness, a broader selection of ion sources is available for a system incorporating a projection column. The ion source may be one that does not emit trace metal ions. Such sources include plasma sources, field emission gas ion sources, or surface plasma sources. Low brightness sources are typically characterized by a brightness of less than 1000 amps per square centimetre per steradian.

The selection of ion sources for the projection column is constrained by the requirement that the emittance of the ion source be sufficiently high to provide an ion flux suitable for excavating a region of the substrate. Emittance is the product of the ion beam's projected area and its beam convergence angle in an optical plane. The emittance required of an ion source in a projection system is typically many orders of magnitude higher than the emittance required of a probe system. An extended discussion of the concepts of emittance and brightness is found in *Principles of Electron Optics* by P. Hawkes and E. Kasper.
In practice, the requirement of high emittance is met by providing an extended source of ions rather than a point source. Examples of extended sources suitable for practice of the invention are given in *Development of Ion Sources for Ion Projection Lithography*, Y. Lee at al., Journal of Vacuum Science and Technology, B 14(6), 3947 (1996).

In an embodiment of the apparatus according to the invention the first angle is selected such that said column axis and said front surface are substantially perpendicular.

In another embodiment of the apparatus according to the invention said second angle is approximately between thirty and sixty degrees.

In yet another embodiment of the apparatus according to the invention the ion beam projection column is equipped to project a mask with an aperture having at least one straight edge.

The shaped-beam ion-projection column can include a mask having an aperture in the shape of the region to be excavated. The mask is typically disposed between the ion source and the wafer surface. The shape of the aperture formed in the mask can be rectangular, triangular, circular, or any other aperture configuration. However, it is preferable that the aperture includes at least one straight edge so that the resulting excavated region of the work-piece has a suitably long vertical wall forming the cross-sectional surface to be imaged by the imaging column.

In an aspect of the invention a method for excavating a cross-section of a work-piece, said work-piece having a front surface, and imaging said cross-section, comprises:
- providing a ion-beam projection column oriented along a column axis, providing a work-piece holder,
- providing a work-piece having a front surface,
- with the work-piece holder orient the front surface of the work-piece substantially normal to the column axis,
- excavate the work-piece by projecting an image aperture onto the front surface of the work-piece, thereby forming a cross-section of the work-piece, and
- imaging the cross-section,
**is characterized in that**
- the ion beam projection column is switchable between a cutting mode in which an aperture image is projected onto said work-piece, and an imaging mode in which a focused ion beam illuminates said work-piece, and
- imaging the cross-section comprises switching the ion beam column to imaging mode, and orient the work-piece such that the angle between the surface of the work-piece and the column axis is a slanted angle, thereby imaging the cross-section using the ion beam projection column.

The cutting mode is well suited for excavating a region of the work piece but cannot readily be used to form an image, while the imaging mode is well suited for imaging but somewhat inefficient for excavation.

In an embodiment of the method according to the invention, after excavating the work-piece and prior to imaging of the cross-section, the front surface of the work-piece is oriented with the work-piece holder such that the angle between the front surface and the column axis is approximately between thirty and sixty degrees.

In another embodiment of the method according to the invention in which projecting an image aperture comprises dithering the image of said image aperture.

Because of imperfections in the formation of an aperture, the edges of the image aperture are not perfectly smooth. In order to mitigate the effect of any roughness in the edges of the image aperture, the projection column optionally includes a dithering system to correct for the effect of roughness on the edges of the aperture.
The dithering system may include deflecting plates connected to a signal source that provides a time-varying electric field between the deflecting plates. Because the ions are charged particles, the time-varying electric field results in time-varying motion of a projected image on the work-piece, By suitably selecting the amplitude and frequency of the signal generated by the signal source, one can smooth out, or average out, the effects of imperfections in the edge of the image aperture, thereby simulating an image aperture having perfectly smooth edges.

In a further embodiment of the method according to the invention dithering the image of said image aperture comprises deflecting the image with a periodic waveform.

Preferably, the signal applied to the deflecting plates has an amplitude selected such that the amplitude of the dithering motion is greater than the roughness of the aperture edges. The signal frequency is selected so that the resulting excavation on the work-piece surface has substantially vertical walls. The preferred waveform generated by the signal generator is a triangular wave having an amplitude and frequency consistent with the foregoing requirements.

The foregoing and other objects, features and advantages of the invention will be apparent from the following description and the accompanying drawings, in which:
FIG. 1 shows a cross-sectional imaging system operating in a cutting mode in which the work-piece surface is normal to an ion beam;
FIG. 2 shows the system of FIG. 1 operated in an imaging mode in which the work-piece surface is tilted relative to the ion beam; and
FIG. 3 is a flow chart illustrating steps followed by the system of FIGS. 1 and 2 in imaging a cross-section of a work-piece.

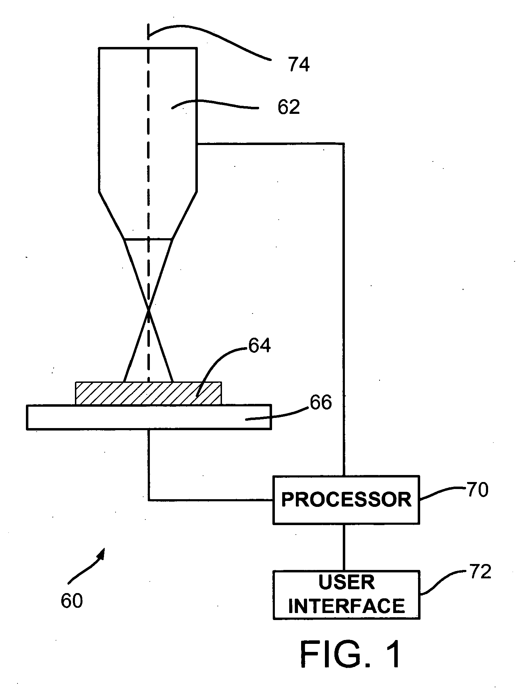

FIG. 1 shows an apparatus **60** equipped with an ion beam column switchable between a projection mode, for excavating the work-piece surface, and an imaging mode, for imaging the cross-section of the work-piece. In the projection mode, the ion beam column **62** projects an image of an aperture onto a work-piece **64,** thereby excavating a portion of its front surface and exposing a cross-sectional surface for imaging.
In the apparatus **60,** a work-piece **64** is mounted on a tilting table **66.** A processor **70** in communication with both the table **66** and the ion beam column **62** controls those elements in response to instructions provided by an operator by means of a user-interface **72** coupled to the processor **70.**
In operation, the ion beam column **62** is operated first in a projection mode, shown in FIG 1, in which the tilting table **66** holds the work-piece **64** such that the surface of the work-piece is normal to a column axis **74** of the ion beam column **62.** During this projection mode, the ion beam column **62** projects an image of an aperture on the work-piece **64.** This results in the exposure of a cross-sectional surface of the work-piece.

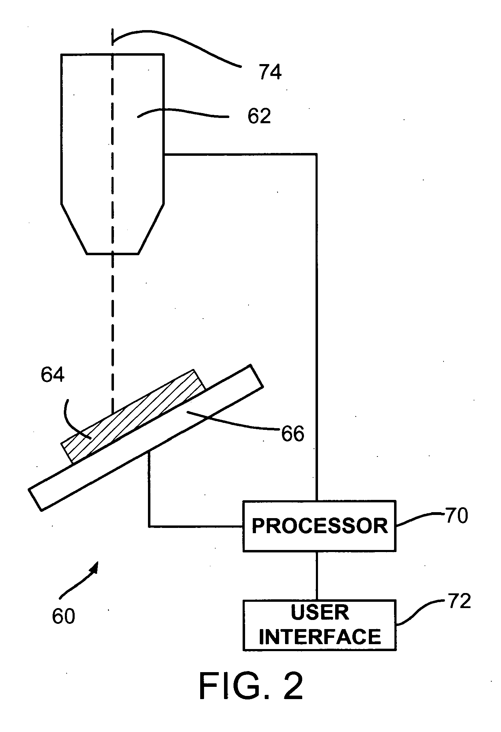

Following the formation of a cross-sectional surface, the ion beam column **62** is operated in an imaging mode, as shown in FIG. 2. During imaging mode, the tilting table **66** holds the surface of the work-piece **64** at an angle relative to the column axis **74** of the ion beam column **62.** This tilt exposes the cross-sectional surface to a focused ion beam generated by the ion beam column **62.** Thus, the ion beam column **62** switches between projecting an image of an aperture on the work-piece **64,** and scanning a focused ion beam on the work-piece. The former mode of operation is well suited for excavating a region of the work-piece but cannot readily be used to form an image.
The latter mode of operation is well suited for imaging but somewhat inefficient for excavation.

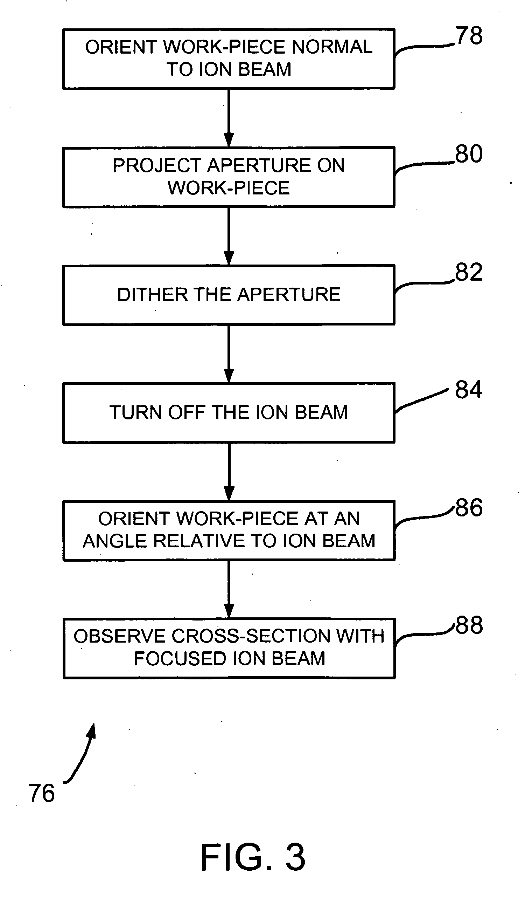

FIG. 3 summarizes the steps in a method **76** for imaging a cross-sectional surface of the work-piece using the system shown in FIGS. 1 and 2. The work-piece is first oriented so that its front surface is normal to the ion beam (step 78). An image of the aperture is then projected onto the work-piece (step **80).** This results in excavation of a region on the work-piece surface. The excavated region has a vertical wall which forms the cross-sectional surface that is later imaged by the imaging column. To the extent that the edges of the aperture are not perfectly smooth, a dithering subsystem dithers the position of the projected aperture on the work-piece (step **82**), thereby averaging out the affect of any irregularities in the edges of the aperture.
After a suitable exposure period, the ion beam is turned off (step **84**). The exposure period depends on the characteristics of the ion source, the properties of the substrate, and the desired depth of the excavated region. Suitable exposure periods are determined either by calculation, using known methods, or empirically. Once the cross-sectional surface has been exposed by the projection column, the work-piece is re-oriented so that its front surface intersects the ion beam at an angle (step **86**). The ion beam is now focused onto the cross-sectional surface and scanned along that surface to form the desired cross-sectional image (step **88**).

## Claims

1. An apparatus for imaging a cross-section of a work-piece having a front surface, said apparatus comprising:
• an ion beam projection column (62) oriented along a column axis (74), equipped to project an aperture image on said work-piece (64),
• a work-piece support (66) equipped to hold the work-piece,
**characterized in that**
• the ion beam projection column is switchable between a cutting mode in which an aperture image is projected onto said work-piece, and an imaging mode in which a focused ion beam illuminates said work-piece under a second angle relative to the column axis, and
• the work-piece support has a cutting position in which said support holds said front surface at a first angle relative to said column axis, and an imaging position in which said support holds said front surface at the second angle relative to said column axis.

2. The apparatus of claim 1 in which the first angle is selected such that said column axis (74) and said front surface are substantially perpendicular.

3. The apparatus according to any of the preceding claims wherein said second angle is approximately between thirty and sixty degrees.

4. The apparatus according to any of the preceding claims in which the ion beam projection column, in operation, projects a mask with an aperture having at least one straight edge.

5. Method for excavating a cross-section of a work-piece, said work-piece having a front surface, and imaging said cross-section, the method comprising:
• providing a ion-beam projection column (62) oriented along a column axis (74),
• providing a work-piece support (66),
• providing a work-piece (64) having a front surface,
• with the work-piece support orienting the front surface of the work-piece substantially normal to the column axis,
• excavate the work-piece by projecting an image aperture onto the front surface of the work-piece, thereby forming a cross-section of the work-piece,
• imaging the cross-section,
**characterized in that**
• the ion beam projection column (62) is switchable between a cutting mode in which an aperture image is projected onto said work-piece (64), and an imaging mode in which a focused ion beam illuminates said work-piece, and
• imaging the cross-section comprises switching the ion beam column to imaging mode, and orient the work-piece such that the angle between the surface of the work-piece and the column axis is a slanted angle,
thereby imaging the cross-section using the ion beam projection column.

6. The method according to claim 5 in which after excavating the work-piece (64) and prior to imaging of the cross-section, the front surface of the work-piece is oriented with the work-piece holder (66) such that the angle between the front surface and the column axis (74) is approximately between thirty and sixty degrees.

7. The method of claim 5 or claim 6 in which projecting an image aperture comprises dithering the image of said image aperture.

8. The method of claim 7 in which dithering the image of said aperture comprises deflecting the image with a periodic waveform.

## Patentansprüche

1. Vorrichtung zum Abbilden eines Querschnitts eines Werkstücks mit einer Vorderfläche, wobei die Vorrichtung aufweist:
- eine entlang einer Säulenachse (74) ausgerichtete Ionenstrahlprojektionssäule (62), die so ausgestattet ist, daß sie ein Aperturbild auf das Werkstück (64) projiziert,
- einen Werkstückträger (66), der so ausgestattet ist, daß er das Werkstück aufnimmt,
**dadurch gekennzeichnet, daß**
- die Ionenstrahlprojektionssäule zwischen einem Schneidmodus, in dem ein Aperturbild auf das Werkstück projiziert wird, und einem Abbildungsmodus umschaltbar ist, in dem ein fokussierter Ionenstrahl das Werkstück unter einem zweiten Winkel zur Säulenachse beleuchtet, und
- das Werkstück eine Schneidposition, in welcher der Träger die Vorderfläche in einem ersten Winkel zur Säulenachse hält, und eine Abbildungsposition aufweist, in welcher der Träger die Vorderfläche in dem zweiten Winkel zur Säulenachse hält.

2. Vorrichtung nach Anspruch 1, wobei der erste Winkel so gewählt ist, daß die Säulenachse (74) und die Vorderfläche im wesentlichen senkrecht zueinander sind.

3. Vorrichtung nach einem der vorstehenden Ansprüche, wobei der zweite Winkel annähernd zwischen 30° und 60° liegt.

4. Vorrichtung nach einem der vorstehenden Ansprüche, wobei die Ionenstrahlprojektionssäule im Betrieb eine Maske mit einer Apertur projiziert, die mindestens eine gerade Kante aufweist.

5. Verfahren zum Freilegen und zum Abbilden eines Werkstückquerschnitts, wobei das Werkstück eine Vorderfläche aufweist, wobei das Verfahren aufweist:
- Bereitstellen einer Ionenstrahlprojektionssäule (62), die entlang einer Säulenachse (74) ausgerichtet ist,
- Bereitstellen eines Werkstückträgers (66),
- Bereitstellen eines Werkstücks (64) mit einer Vorderfläche,
- wobei der Werkstückträger die Vorderfläche des Werkstücks im wesentlichen senkrecht zur Säulenachse ausrichtet,
- Abtragen des Werkstücks durch Projektion einer Bildapertur auf die Vorderfläche des Werkstücks, wodurch ein Querschnitt des Werkstücks gebildet wird,
- Abbilden des Querschnitts,
**dadurch gekennzeichnet, daß**
- die Ionenstrahlprojektionssäule (62) zwischen einem Schneidmodus, in dem ein Aperturbild auf das Werkstück (64) projiziert wird, und einem Abbildungsmodus umschaltbar ist, in dem ein fokussierter Ionenstrahl das Werkstück beleuchtet, und
- das Abbilden des Querschnitts ein Umschalten der Ionenstrahlprojektionssäule zum Abbildungsmodus und die Ausrichtung des Werkstücks aufweist, so daß der Winkel zwischen der Oberfläche des Werkstücks und der Säulenachse ein schräger Winkel ist,
wodurch der Querschnitt unter Verwendung der Ionenstrahlprojektionssäule abgebildet wird.

6. Verfahren nach Anspruch 5, wobei nach dem Abtragen des Werkstücks (64) und vor dem Abbilden des Querschnitts die Vorderfläche des Werkstücks mit dem Werkstückträger (66) so ausgerichtet wird, daß der Winkel zwischen der Vorderfläche und der Säulenachse (74) annähernd zwischen 30° und 60° liegt.

7. Verfahren nach Anspruch 5 oder Anspruch 6, wobei die Projektion einer Bildapertur eine Ausgleichsmodulation des Bildes der Bildapertur aufweist.

8. Verfahren nach Anspruch 7, wobei die Ausgleichsmodulation des Aperturbildes eine Ablenkung des Bildes mit einer periodischen Wellenform aufweist.

## Revendications

1. Dispositif d'imagerie d'une section transversale d'une pièce de fabrication ayant une surface frontale, ledit dispositif comprenant :
une colonne de projection de faisceau d'ions (62) orientée le long de l'axe de la colonne (74), équipée pour projeter une image d'ouverture sur ladite pièce de fabrication (64),
un support de pièce de fabrication (66) équipé pour maintenir la pièce de fabrication,
**caractérisé en ce que**
la colonne de projection de faisceau d'ions est commutable entre un mode de coupe dans lequel une image d'ouverture est projetée sur ladite pièce de fabrication et un mode d'imagerie dans lequel un faisceau d'ions focalisé illumine ladite pièce de fabrication sous un deuxième angle par rapport à l'axe de la colonne, et
le support de pièce de fabrication comporte une position de coupe dans laquelle ledit support maintient ladite surface frontale à un premier angle par rapport audit axe de colonne et une position d'imagerie dans laquelle ledit support maintient ladite surface frontale au deuxième angle par rapport audit axe de colonne.

2. Dispositif selon la revendication 1, dans lequel le premier angle est choisi de façon que ledit axe de colonne (74) et ladite surface frontale soient sensiblement perpendiculaires.

3. Dispositif selon l'une quelconque des revendications précédentes, dans lequel ledit deuxième angle est compris approximativement entre trente et soixante degrés.

4. Dispositif selon l'une quelconque des revendications précédentes, dans lequel la colonne de projection de faisceau d'ions projette, en fonctionnement, un masque avec une ouverture ayant au moins un bord rectiligne.

5. Procédé de creusement de la section transversale d'une pièce de fabrication ayant une surface frontale, et d'imagerie de ladite section transversale, le procédé comprenant :
la fourniture d'une colonne de projection de faisceau d'ions (62) orientée le long de l'axe de la colonne (74),
la fourniture d'un support de pièce de fabrication (66),
la fourniture d'une pièce de fabrication (64) ayant une surface frontale,
le support de pièce de fabrication orientant la surface frontale de manière sensiblement normale par rapport à l'axe de colonne,
le creusement de la pièce de fabrication par projection d'une image d'ouverture sur la surface frontale de la pièce de fabrication, de manière à former une section transversale de la pièce de fabrication,
la formation de l'image de la section transversale,
**caractérisé en ce que**
la colonne de projection de faisceau d'ions (62) est commutable entre un mode de coupe dans lequel une image d'ouverture est projetée sur ladite pièce de fabrication (64) et un mode d'imagerie dans lequel un faisceau d'ions focalisé illumine ladite pièce de fabrication, et
la formation de l'image de la section transversale comprend la commutation de la colonne de faisceau d'ions vers le mode d'imagerie et l'orientation de la pièce de fabrication de façon que l'angle entre la surface de la pièce de fabrication et l'axe de la colonne soit un angle incliné, formant ainsi l'image de la section transversale en utilisant la colonne de projection de faisceaux d'ions.

6. Procédé selon la revendication 5, dans lequel après creusement de la pièce de fabrication (64) et avant formation de l'image de la section transversale, la surface frontale de la pièce de fabrication est orientée, le support de pièce de fabrication (66) étant tel que l'angle entre la surface frontale et l'axe de colonne (74) est compris approximativement entre trente et soixante degrés.

7. Procédé selon la revendication 5 ou la revendication 6, dans lequel la projection d'une image d'ouverture comprend le tramage de l'image de ladite image d'ouverture.

8. Procédé selon la revendication 7, dans lequel le tramage de l'image de ladite ouverture comprend la déviation de l'image avec une forme d'onde périodique.
